# EUROPÄISCHE PATENTANMELDUNG

(11) **EP 0 993 046 A2**
(43) Veröffentlichungstag der Anmeldung: **12.04.2000**
(21) Anmeldenummer: 99118270.0
(22) Anmeldetag: 14.09.1999
(51) Int. Cl.: H01L 27/02, H01L 27/118

(54) **Verfahren zum Einbauen von Schutz-Bauelementen in aus Standardzellen aufgebauten integrierten Schaltungen**

(30) Priorität: 28.09.1998 DE 19844405
(71) Anmelder: SIEMENS AKTIENGESELLSCHAFT, 80333 München (DE)
(72) Erfinder: Thiele, Jörg, Dr., 80636 München (DE); Hübl, Markus, 85570 Markt Schwaben (DE)

(57) **Zusammenfassung**

Die Erfindung betrifft ein Verfahren zum Einbauen von Schutz-Bauelementen in aus Standardzellen aufgebauten integrierten Schaltungen, bei dem
(a) in den Standardzellen der für wenigstens ein Schutz-Bauelement benötigte Platz reserviert wird,
(b) nach Verdrahtung der Standardzellen diejenigen Standardzellen bestimmt werden, die ein Schutz-Bauelement erfordern, und
(c) in die so bestimmten Standardzellen die Schutz-Bauelemente eingesetzt werden.

## Beschreibung

Die vorliegende Erfindung betrifft ein Verfahren zum Einbauen von Schutz-Bauelementen in aus Standardzellen aufgebauten integrierten Schaltungen.

In integrierten Schaltungen wird häufig der Einbau von Schutzdioden, die auch als "Tie-Down-Dioden" bezeichnet werden, vorgesehen, um Ladungen abzuführen, die beim Prozessieren, wie beispielsweise Ätzen, von Metallagen bei der Herstellung der integrierten Schaltung entstehen. So ist bekannt, daß beim reaktiven Ionenätzen (RIE) Aufladungen erfolgen, die zu Spannungen bis zu einigen 100 V führen können. Nach Zusammenbau einer integrierten Schaltung aus Standardzellen, also nach Vernetzung dieser Standardzellen, wird der durch die Aufladung entstandene Spannungsabfall beispielsweise an das Gateoxid von MOS-Feldeffekttransistoren, die in den Standardzellen enthalten sind, angelegt. Ein Spannungsdurchbruch im Gateoxid führt zwar gewöhnlich lediglich zu mikroskopischen Schäden, die zunächst einen weiteren Betrieb der den Transistor enthaltenden Schaltung nicht beeinträchtigen. Jedoch ist die Lebensdauer von solchen Transistoren verkürzt, so daß die integrierte Schaltung insgesamt oft aus nicht erkennbaren Ursachen vorzeitig ausfällt, wenn infolge eines solchen mikroskopischen Schadens ein Transistor in seiner Funktionsfähigkeit schließlich zerstört ist.

Es hat sich gezeigt, daß für den Ausfall eines Transistors infolge eines zu großen Spannungsabfalles über seinem Gateoxid das Flächenverhältnis (Fläche Metall/Fläche Transistor) entscheidend ist: ist dieses Flächenverhältnis kleiner als ein spezifischer Wert, so ist keine Zerstörung des Gateoxids zu befürchten. Liegt dieses Verhältnis aber über dem spezifischen Wert, so muß damit gerechnet werden, daß die beim Prozessieren der Metallagen erzeugten Ladungen zu Spannungen führen, die nach dem Vernetzen der Standardzellen zu Beschädigungen der Gateoxide von MOS-Feldeffekttransistoren führen können.

Um dieses Problem zu vermeiden, werden bisher in sogenannten "Full-Custom-" bzw. "per Hand" optimierten Schaltungen Schutzdioden in die jeweiligen Layouts eingefügt und dann in die tatsächlichen integrierten Schaltungen eingebaut. Für eine aus Standardzellen bestehende integrierte Schaltung ist ein derartiges Vorgehen nicht möglich, da es zu aufwendig wäre, jede der zahlreichen Standardzellen auf diese Weise mit Schutzdioden auszustatten. Die Alternative hierzu, nämlich Schutzdioden in jede Standardzelle einzubauen, führt zu einer sehr großen Anzahl von Schutzdioden, wodurch die integrierte Schaltung in unnötiger Weise mit den Kapazitäten aller Schutzdioden belastet wird, was letztlich einen nachteilhaften Einfluß auf die Schaltgeschwindigkeit der integrierten Schaltung ausübt.

Es ist daher Aufgabe der vorliegenden Erfindung, ein Verfahren zum Einbauen von Schutz-Bauelementen in aus Standardzellen aufgebauten integrierten Schaltungen zu schaffen, bei dem in wirtschaftlicher Weise solche Schutz-Bauelemente ohne weiteres nur in solchen Standardzellen vorgesehen werden, die diese Schutz-Bauelemente tatsächlich benötigen.

Zur Lösung dieser Aufgabe sieht die vorliegende Erfindung ein Verfahren zum Einbauen von Schutz-Bauelementen in aus Standardzellen aufgebauten integrierten Schaltungen vor, bei dem:
(a) in den Standardzellen der für wenigstens ein Schutz-Bauelement benötigte Platz reserviert wird,
(b) nach Verdrahtung der Standardzellen diejenigen Standardzellen bestimmt werden, die ein Schutz-Bauelement erfordern, und
(c) in die so bestimmten Standardzellen die Schutz-Bauelemente eingesetzt werden.

In zweckmäßiger Weise wird der für ein Schutz-Bauelement benötigte Platz im Layout der integrierten Schaltung durch einen Platzhalter markiert.

Für das Schutz-Bauelement wird in vorteilhafter Weise eine Schutzdiode vorgesehen. Allerdings kann das Schutz-Bauelement auch beispielsweise aus einer Kapazität bestehen.

Das erfindungsgemäße Verfahren ist von besonderem Vorteil, wenn integrierte Schaltungen aus Standardzellen-Bibliotheken aufgebaut werden. Seine Anwendung sorgt dann dafür, daß Schutz-Bauelemente und insbesondere Schutzdioden ohne weiteres an den durch "Platzhalter" markierten Stellen eingesetzt werden können, welche tatsächlich ein solches Schutz-Bauelement erfordern, da in ihnen das oben erwähnte Verhältnis aus (Fläche Metall)/(Fläche Transistor) eine spezifische Größe überschreitet.

Bei dem erfindungsgemäßen Verfahren wird so in jeder Standardzelle der für ein Schutz-Bauelement benötigte Platz reserviert, um später bei Bedarf dort das Schutz-Bauelement einsetzen zu können. Die vorgesehene Einbaufläche kann dabei auf dem Layout mit einer Markierungsfunktion als Platzhalter versehen werden. Ein Anschluß beispielsweise eines zu schützenden Gates an eine gegebenenfalls später beizufügende Schutzdiode kann in bevorzugter Weise bereits beim Aufbau der Standardzelle vorgesehen werden.

Durch ein nach der Verdrahtung der Standardzelle eingesetztes CAD-Verfahren (CAD = computergestütztes Design) werden alle Bauelemente der einzelnen Standardzellen bzw. deren Gateoxide identifiziert, die durch Schutzdioden als Schutz-Bauelemente gesichert werden müssen. Nur diese Bauelemente werden dann mit den entsprechenden Schutzdioden versehen.

Der Einbau der Schutz-Bauelemente kann automatisch erfolgen. Es werden dabei nur an den Stellen Schutz-Bauelemente eingesetzt, wo diese tatsächlich gemäß den verwendeten Designregeln und insbesondere gemäß dem obigen Verhältnis aus (Fläche Metall)/(Fläche Transistor) benötigt werden. Damit werden insbesondere keine unnötigen parasitären Kapazitäten eingebaut, so daß auch nicht die Schaltgeschwindigkeit der integrierten Schaltung in unnötiger Weise verschlechtert wird. Mit anderen Worten, eine entsprechend dem erfindungsgemäßen Verfahren hergestellte integrierte Schaltung weist eine erheblich höhere Schaltgeschwindigkeit als eine integrierte Schaltung auf, bei der bereits alle Standardzellen mit Schutz-Bauelementen ausgestattet sind. Durch die Verwendung der Markierungsfiguren als Platzhalter ist sichergestellt, daß die Schutz-Bauelemente an geeigneten Stellen der einzelnen Standardzellen nachträglich ohne weiteres eingefügt werden können. Es sei noch angemerkt, daß das erfindungsgemäße Verfahren eine erhebliche Steigerung an Ausbeute sowie Zuverlässigkeit gegenüber integrierten Schaltungen erlaubt, bei denen auf den Einbau von Schutz-Bauelementen und insbesondere Schutzdioden vollkommen verzichtet wird.

Bei den Standardzellen kann es sich beispielsweise auch um Gate-Arrays handeln. Bei solchen Gate-Arrays wird dann für Schutzdioden ein Platz vorgesehen. Diese Schutzdioden können in einem Standardzellen-Master auch schon vorhanden sein. Bei Bedarf werden die jeweiligen Schutzdioden in die entsprechenden Gate-Arrays eingebaut, was beispielsweise durch Einfügen von Kontakten zwischen den Schutzdioden und mit zu schützenden Gates verbundenen Anschlüssen geschehen kann.

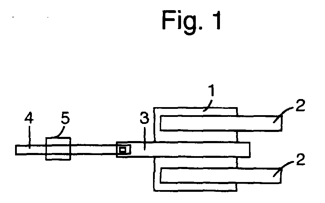

Nachfolgend wird die Erfindung anhand der Zeichnung näher erläutert, in deren einziger Figur das Layout eines MOS-Feldeffekttransistors mit einer parallel zu seiner Gateelektrode liegenden Markierungsfigur für eine Schutzdiode dargestellt ist.

Ein MOS-Transistor mit Diffusionsgebieten 1, Drain- bzw. Sourceelektroden 2 und einer Gateelektrode 3 ist in einer nicht gezeigten Standardzelle vorgesehen. Liegt das Verhältnis (Fläche Metall)/(Fläche Transistor) bei diesem MOS-Feldeffekttransistor unter einem spezifischen Wert, so steht zu befürchten, daß beim Prozessieren einer aus Standardzellen aufgebauten integrierten Schaltung das Gateoxid übermäßig mit Spannungen belastet wird, die auf Ladungen zurückgehen, die bei diesem Prozessieren entstehen. Daher sollte vorsorglich parallel zu der Gateelektrode eine Schutzdiode als Beispiel eines Schutz-Bauelementes vorgesehen werden. Hierzu wird erfindungsgemäß im Layout der integrierten Schaltung in einer von der Gateelektrode wegführenden Leitung 4 durch eine Markierungsfigur ein Platzhalter 5 vorgesehen, an welchem ohne weiteres nach dem Aufbau der integrierten Schaltung aus den einzelnen Standardzellen eine Schutzdiode untergebracht werden kann. Nach dem tatsächlichen Aufbau der integrierten Schaltung aus den Standardzellen werden zunächst diejenigen Standardzellen festgelegt, bei denen eine Schutzdiode erforderlich ist. In die so bestimmten Standardzellen werden dann die Schutzdioden eingesetzt, was ohne weiteres möglich ist, da im Layout durch die Platzhalter 5 bereits dafür gesorgt ist, daß für diese Schutzdioden ausreichend Platz vorhanden ist, so daß die Schutzdioden ohne weiteres eingesetzt werden können.

Durch die vorliegende Erfindung wird somit ein Verfahren geschaffen, mit dem es möglich ist, bei einer aus Standardzellen aufgebauten integrierten Schaltung Schutz-Bauelemente nur für die Standardzellen ohne weiteres vorzusehen, die tatsächlich solche Schutz-Bauelemente benötigen.

## Patentansprüche

1. Verfahren zum Einbauen von Schutz-Bauelementen in aus Standardzellen aufgebauten integrierten Schaltungen, bei dem
(a) in den Standardzellen der für wenigstens ein Schutz-Bauelement benötigte Platz reserviert wird,
(b) nach Verdrahtung der Standardzellen diejenigen Standardzellen bestimmt werden, die ein Schutz-Bauelement erfordern, und
(c) in die so bestimmten Standardzellen die Schutz-Bauelemente eingesetzt werden.

2. Verfahren nach Anspruch 1,
**dadurch gekennzeichnet,**
daß der für ein Schutz-Bauelement benötigte Platz im Layout der integrierten Schaltung durch einen Platzhalter (5) markiert wird.

3. Verfahren nach Anspruch 1,
**dadurch gekennzeichnet,**
daß für das Schutz-Bauelement eine Schutzdiode vorgesehen wird.

4. Verfahren nach einem der Ansprüche 1 bis 3,
**dadurch gekennzeichnet,**
daß Anschlüsse für Schutz-Bauelemente in den Standardzellen vorgesehen werden.

5. Verfahren nach einem der Ansprüche 1 bis 4,
**dadurch gekennzeichnet,**
daß die Standardzellen Gate-Arrays sind.
